# EUROPEAN PATENT APPLICATION

(11) **EP 0 730 203 A2**
(43) Date of publication of application: **04.09.1996**
(21) Application number: 96103197.8
(22) Date of filing: 01.03.1996
(51) Int. Cl.: G03F 7/12

(54) **Silk screen coating apparatus**

(30) Priority: 03.03.1995 JP 70906/95
(71) Applicant: Yugen Kaisha Ohkuma Engineering, Uji-shi, Kyoto (JP)
(72) Inventor: Ohkuma, Seiji, Uji-shi, Kyoto (JP)
(74) Representative: Abitz, Walter, Dr.-Ing.

(57) **Abstract**

According to the invention, there is provided a silk or metal screen coating apparatus including a pair of squeegee buckets between which a screen frame is inserted. The screen frame extends vertically between the squeegee buckets and defines an opening surrounded by the periphery thereof. A silk or metal screen is stretched in the opening and held by the periphery of the screen frame. The squeegee buckets extend horizontally to be opposed to each other on the opposite sides of the screen frame. A sensitizing or reinforcing agent is received in the squeegee buckets. The squeegee buckets are moved upwardly along the screen for coating the sensitizing or reinforcing agent onto the both faces of the screen. The apparatus comprises a pair of one end carriages disposed in positions corresponding to one ends of the squeegee buckets and spaced from each other in the opposed direction of the squeegee buckets. The squeegee buckets are carried at one ends by the one end carriages separately from each other. The apparatus further comprises a pair of one end pillars extending vertically. The one end pillars are disposed in positions corresponding to one ends of the squeegee buckets and spaced from each other in the opposed direction of the squeegee buckets. The one end carriages are engaged with the one end pillars separately from each other to be moved upwardly along the one end pillars so that the squeegee buckets are moved upwardly along the screen. Accordingly, in the apparatus, the screen frame can be passed between the one end pillars and between the one end carriages to be inserted between the squeegee buckets.

## Description

### FIELD OF THE INVENTION

The invention relates to a silk or metal screen used in a printing process. In particular, the invention relates to a silk or metal screen coating apparatus for coating a sensitizing or reinforcing agent onto the both faces of the screen, before printing and developing the screen.

### PRIOR ART

In general, a silk screen has been used in a printing process. A metal screen may be substituted for the silk screen in the printing process. In this connection, there has been used a silk or metal screen coating apparatus including a pair of squeegee buckets between which a screen frame is inserted. The screen frame extends vertically between the squeegee buckets an, defines an opening surrounded by the periphery thereof. A silk or metal screen is stretched in the opening and held by the periphery of the screen frame. The squeegee buckets extend horizontally to be opposed to each other on the opposite sides of the screen frame. A sensitizing or reinforcing agent is received in the squeegee buckets.

In the apparatus, heretofore, the squeegee buckets have been carried at one ends by a single common one end carriage and carried at the other ends by a single common other end carriage. The one end carriage is engaged with a one end pillar extending vertically. The other end carriage is engaged with an other end pillar extending vertically. The one end and other end carriages are moved upwardly along the one end and other end pillars so that the squeegee buckets are moved upwardly along the screen of the screen frame for coating the sensitizing or reinforcing agent onto the both faces of the screen. This arrangement has been traditional and unchanged.

However, the apparatus has a problem of handling the screen frame. In order to insert the screen frame between the squeegee buckets, the screen frame has to be lifted by an operator to a level above the squeegee buckets, in front of the apparatus. The screen frame is then moved in the opposed direction of the squeegee buckets, passed over one of the squeegee buckets and inserted between the squeegee buckets. The screen frame has a large size. It is therefore a troublesome work with labour and time to insert the screen frame between the squeegee buckets. The screen frame may be caught on the edges of squeegee buckets when passed over one of squeegee buckets and inserted between the squeegee buckets, to thereby spill the sensitizing or reinforcing agent from the squeegee buckets. The screen of the screen frame may be damaged by the edges of squeegee buckets. In addition, owing to the single common one end carriage and the single common other end carriage, a resonance may be generated between the squeegee buckets when the squeegee buckets are moved upwardly along the screen, to make the sensitizing or reinforcing agent uneven or striped on the both faces of the screen.

### SUMMARY OF THE INVENTION

It is an object of the invention is to provide a new and improved coating apparatus including a pair of squeegee buckets, for coating a sensitizing or reinforcing agent onto the both faces of a screen, to thereby overcome the problems described above.

Other object of the invention is to insert the screen frame between the squeegee buckets without difficulty, labour and time.

Other object of the invention is to automatically insert the screen frame between the squeegee buckets.

Other object of the invention is to keep the sensitizing or reinforcing agent in the squeegee buckets from spilling, and keep the screen of the screen frame from being damaged.

Other object of the invention is to prevent a resonance from being generated between the squeegee buckets when the squeegee buckets are moved upwardly along the screen, to coat the sensitizing or reinforcing agent onto the both faces of the screen without making it uneven or striped.

According to the invention, there is provided a silk or metal screen coating apparatus including a pair of squeegee buckets between which a screen frame is inserted. The screen frame extends vertically between the squeegee buckets and defines an opening surrounded by the periphery thereof. A silk or metal screen is stretched in the opening and held by the periphery of the screen frame. The squeegee buckets extend horizontally to be opposed to each other on the opposite sides of the screen frame. A sensitizing or reinforcing agent is received in the squeegee buckets. The squeegee buckets are moved upwardly along the screen for coating the sensitizing or reinforcing agent onto the both faces of the screen.

The apparatus comprises a pair of one end carriages disposed in positions corresponding to one ends of the squeegee buckets and spaced from each other in the opposed direction of the squeegee buckets. The squeegee buckets are carried at one ends by the one end carriages separately from each other. The apparatus further comprises a pair of one end pillars extending vertically. The one end pillars are disposed in positions corresponding to one ends of the squeegee buckets and spaced from each other in the opposed direction of the squeegee buckets. The one end carriages are engaged with the one end pillars separately from each other to be moved upwardly along the one end pillars so that the squeegee buckets are moved upwardly along the screen. Accordingly, in the apparatus, the screen frame can be passed between the one end pillars and between the one end carriages to be inserted between the squeegee buckets.

In a preferred embodiment, a pair of other end carriages are disposed in positions corresponding to the other ends of the squeegee buckets and spaced from each other in the opposed direction of the squeegee buckets. The squeegee buckets are carried at the other ends by the other end carriages separately from each other. A pair of other end pillars extend vertically. The other end pillars are disposed in positions corresponding to the other ends of the squeegee buckets and spaced from each other in the opposed direction of the squeegee buckets. The other end carriages are engaged with the other end pillars separately from each other to be moved along the other end pillars so that the squeegee buckets are moved upwardly along the screen. Accordingly, the screen frame can be passed between the other end pillars and between the other end carriages to be drawn out to the exterior.

The one end and other end carriages include rollers mounted thereon for rotation and engaged with the one end and other end pillars so that the one end and other end carriages can be moved upwardly and downwardly along the one end and other end pillars, respectively. The one end and other end pillars are fixedly mounted on the base-frame of the apparatus. The base frame is supported by casters for movement along a floor.

A pair of one end timing belts extend parallel to the one end pillars. The one end timing belts are connected to the one end carriages so that the one end carriages can be pulled upwardly and downwardly by the one end timing belts. A pair of other end timing belts extend parallel to the other end pillars. The other end timing belts are connected to the other end carriages so that the other end carriages can be pulled upwardly and downwardly by the other end timing belts.

The apparatus further comprises upper and lower rails for the screen frame. The upper and lower rails extend horizontally and parallel to the squeegee buckets in positions above and below the squeegee buckets so that the screen frame is moved along the upper and lower rails to be inserted between the squeegee buckets.

A pair of cylinders are mounted on the upper rail. Plungers are received in the cylinders to be pushed against the screen frame so that the screen frame can be fixedly held by the plungers of the cylinders. Rollers are installed in the lower rail for rotation so that the screen frame is supported on the rollers for movement. A stop is mounted on the lower rail so that the screen frame can be engaged with and stopped by the stop.

The apparatus further comprises additional carriages by which the upper rail is carried at one end and at the other end. The additional carriages include rollers mounted thereon for rotation and engaged with the one end and other end pillars so that the additional carriages can be moved upwardly and downwardly along the one end and other end pillars. Additional timing belts extend parallel to the one end and other end pillars. The additional timing belts are connected to the additional carriages so that the additional carriages can be pulled upwardly and downwarly by the additional timing belts. The upper rail is moved upwardly or downwardly by the additional carriages to adjust the level thereof in accordance with the size of the screen frame. As to the lower rail, means is provided for moving the stop along the lower rail to adjust the position thereof in accordance with the size of the screen frame.

### BRIEF DESCRIPTION OF THE DRAWINGS

Fig. 1 is an elevational view of a preferred embodiment of the invention.

Fig. 2 is a side view of the apparatus in Fig. 1.

Fig. 3 is an enlarged view of the one end carriage in Fig. 2.

Fig. 4 is an explanatory view of the squeegee buckets in Fig. 2.

### DETAILED DESCRIPTION OF THE PREFERRED EMBODIMENT

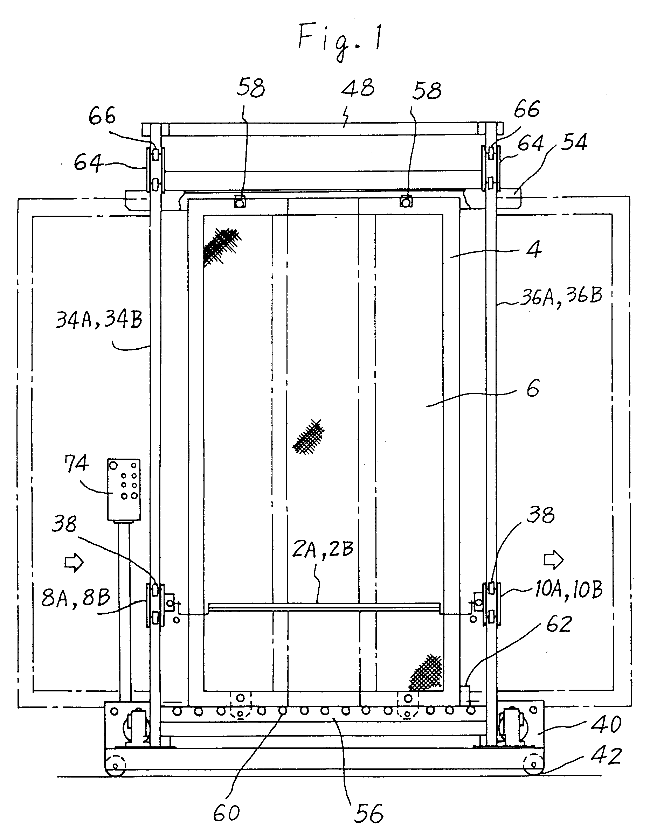

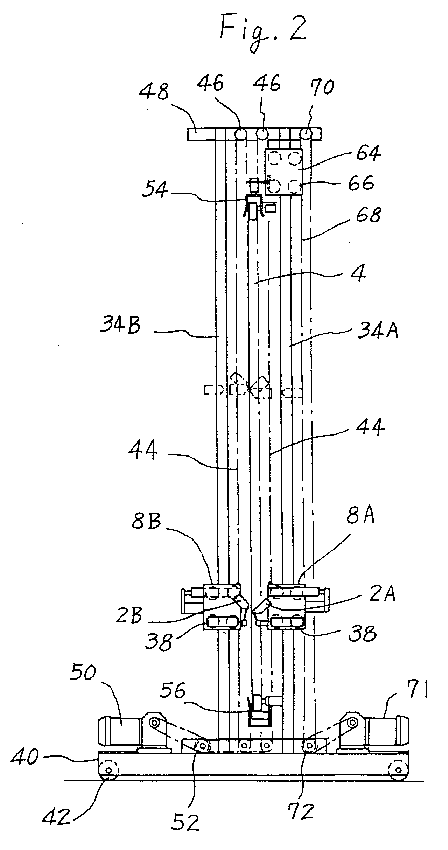

Referring to Figs. 1 and 2, a silk or metal screen coating apparatus according to the invention is shown, which includes a pair of squeegee buckets 2A and 2B between which a screen frame 4 is inserted. The screen frame 4 extends vertically between the squeegee buckets 2A and 2B and defines an opening surrounded by the periphery thereof. A silk or metal screen 6 is stretched in the opening and held by the periphery of the screen frame 4. The squeegee buckets 2A and 2B extend horizontally to be opposed to each other on the opposite sides of the screen frame 4. A sensitizing or reinforcing agent is received in the squeegee buckets 2A and 2B.

The apparatus comprises a pair of one end carriages 8A and 8B disposed in positions corresponding to one ends of the squeegee buckets 2A and 2B and spaced to each other in the opposed direction of the squeegee buckets 2A and 2B. The squeegee buckets 2A and 2B are carried at one ends by the one end carriages 8A and 8B separately from each other. A pair of other end carriages 10A and 10B are disposed in positions corresponding to the other ends of the squeegee buckets 2A and 2B and spaced to each other in the opposed direction of the squeegee buckets 2A and 2B. The squeegee buckets 2A and 2B are carried at the other ends by the other end carriages 10A and 10B separately from each other.

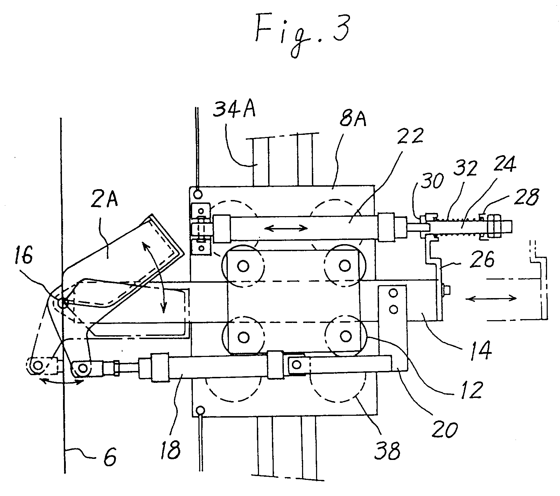

In the embodiment, the one end carriages 8A and 8B have structures symmetrical to each other. The one end carriages 8A and 8B each includes rollers 12 mounted thereon for rotation, and a bar 14 supported by the rollers 12 for longitudinal movement, as shown in Fig. 3. The squeegee bucket 2A or 2B is pivotally mounted at one end on the bar 14 by a pin 16. A cylinder 18 is fixedly attached to the bar 14 by means of a bracket 20 and operatively connected to the squeegee bucket 2A or 2B. In addition, the one end carriages 8A and 8B each includes a cylinder 22 supported thereby and a rod 24 connected to and supported by the cylinder 22. The rod 24 is fitted into a hole formed in a plate 26 which is fixedly mounted on the bar 14. The rod 24 includes a collar 28 and a stop 30 fixedly mounted thereon and a spring 32 disposed between the plate 26 and the collar 28 so that the plate 26 is resiliently urged by the spring 32 acid engaged with the stop 30.

The other end carriages 10A and 10B each has the same structure as the one end carriages 8A and 8B, in which the squeegee bucket 2A or 2B is pivotally mounted at the other end on the bar 14 by the pin 16. In the one end and other end carriages 8A, 8B, 10A and 10B, the bars 14 can therefore be moved longitudinally by the cylinders 22, the rods 24 and the plates 26 so that the squeegee buckets 2A and 2B are advanced toward and retracted from the screen 6 of the screen frame 4. The squeegee buckets 2A and 2B can also pivotally moved about the pins 16 by the cylinders 18.

The apparatus further comprises a pair of one end pillars 34A and 34B extending vertically. The one end pillars 34A and 34B are disposed in positions corresponding to one ends of the squeegee buckets 2A and 2B and spaced to each other in the opposed direction of the squeegee buckets 2A and 2B. The one end carriages 8A and 8B are engaged with the one end pillars 34A and 34B separately from each other to be moved upwardly along the one end pillars 34A and 34B. The apparatus further comprises a pair of other end pillars 36A and 36B extending vertically. The other end pillars 36A and 36B are disposed in positions corresponding to the other ends of the squeegee buckets 2A and 2B and spaced to each other in the opposed direction of the squeegee buckets 2A and 2B. The other end carriages 10A and 10B are engaged with the other end pillars 36A and 36B separately from each other to be moved upwardly along the other end pillars 36A and 36B. In the embodiment, the one end and other end carriages 8A, 8B, 10A and 10B include rollers 38 mounted thereon for rotation and engaged with the one end and other end pillars 34A, 34B, 36A and 36B so that the one end and other end carriages 8A, 8B, 10A and 10B can be moved upwardly and downwardly along the one end and other end pillars 34A, 34B, 36A and 36B, respectively. The one end and other end pillars 34A, 34B, 36A and 36B are fixedly mounted on the base frame 40 of the apparatus. The base frame 40 is supported by casters 42 for movement along a floor.

A pair of one end timing belts 44 are disposed between the one end pillars 34A and 34B to extend parallel to the one end pillars 34A and 34B. The one end timing belts 44 are engaged with idle sprockets 46 and connected to the one end carriages 8A and 8B. The idle sprockets 46 are mounted on the top frame 48 of the apparatus for rotation. The one end timing belts 44 are further connected to a one end motor 50 by means of a drive sprocket 52 so that the one end carriages 8A and 8B can be pulled upwardly and downwardly by the one end timing belts 44. Like the one end timing belts 44, the one end pillars 34A and 34B, the one end carriages 8A and 8B and the one end motor 50, a pair of other end timing belts are disposed between the other end pillars 36A and 36B to extend parallel to the other end pillars 36A and 36B. The other end timing belts are connected to the other end carriages 10A and 10B and an other end motor so that the other end carriages 10A and 10B can be pulled upwardly and downwardly by the other end timing belts. The one end and other end motors 50 are fixedly mounted on the base frame 40.

In addition, the apparatus includes upper and lower rails 54 and 56 for the screen frame 4. The upper and lower rails 54 and 56 extend horizontally and parallel to the squeegee buckets 2A and 2B in positions above and below the squeegee buckets 2A and 2B. The upper rail 54 has a channel section opening downwardly to receive the upper edge of the screen frame 4. The upper rail 54 further includes a pair of cylinders 58 mounted thereon. Plungers are received in the cylinders 58 to be pushed against the screen frame 4 so that the screen frame 4 can be fixedly held by the plungers of the cylinders 58. The lower rail 56 has a channel section opening upwardly to receive the lower edge of the screen frame 4. Rollers 60 are installed in the lower rail 56 for rotation so that the screen frame 4 can ride on the rollers 60. A stop 62 is mounted on the lower rail 56 so that the screen frame 4 can be engaged with the stop 62. Means is provided for moving the stop 62 along the lower rail 56 to adjust the position thereof.

The upper rail 54 is carried at one end and at the other end by additional carriages 64 which include rollers 66 mounted thereon for rotation and engaged with the one end and other end pillars 34A and 36A so that the additional carriages 64 can be moved upwardly and downwardly along the one end and other end pillars 34A and 36A. In this connection, additional timing belts 68 extend parallel to the one end and other end pillars 34A and 36A. The additional timing belts 68 are engaged with idle sprockets 70 and connected to the additional carriages 64. The additional timing belts 68 are further connected to additional motors 71 by means of drive sprockets 72 so that the additional carriages 64 can be pulled upwardly and downwardly by the additional timing belts 68. The additional motors 71 are fixedly mounted on the base frame 40.

The apparatus further includes a control means 74 connected to the cylinders 18, 22 and 58 and the motors 50 and 71 to sequentially operate and control the cylinders 18, 22 and 58 and the motors 50 and 71.

In the apparatus, in order to insert the screen frame 4 between the squeegee buckets 2A and 2B, the screen frame 4 is handled on one side of the apparatus. The screen frame 4 is then pushed and passed between the one end pillars 34A and 34B and between the one end carriages 8A and 8B, and moved along the upper and lower rails 54 and 56 to be inserted between the squeegee buckets 2A and 2B. In the lower rail 56, the screen frame 4 is supported on and guided by the rollers 60 for movement. The screen frame 4 is engaged with and stopped by the stop 62 when inserted between the squeegee buckets 2A and 2B. In the upper rail 54, the cylinders 58 is then operated by the control means 74 so that the screen frame 4 is fixedly held by the plungers of the cylinders 58.

In the one end and other end carriages 8A, 8B, 10A and 10B, the cylinders 22 are then operated by the control means 74. The rods 24 are moved longitudinally by the cylinders 22 so that the squeegee buckets 2A and 2B are advanced toward the screen 6 of the screen frame 4. The squeegee buckets 2A and 2B are engaged with the both faces of the screen 6. The rods 24 are further moved so that springs 32 are compressed between the plates 26 and the collars 28. The squeegee buckets 2A and 2B are therefore resiliently urged by the springs 32 and pushed against the both faces of the screen 6. The cylinders 18 are then operated by the control means 74 so that the squeegee buckets 2A and 2B are pivotally moved about the pans 16 by the cylinders 18 and inclined at an angle with respect to the screen 6, as shown by solid line in Fig. 3.

The motors 50 are then driven by the control means 74 so that the one end and other end timing belts 44 are operated by the motors 50 and the drive sprockets 52. The one end and other end carriages 8A, 8B, 10A and 10B are pulled upwardly by the one end and other end timing belts 44 and moved upwardly along the one end and other end pillars 34A, 34B, 36A and 36B. The one end and other end squeegee buckets 2A and 2B are therefore moved upwardly along the screen 6 of the screen frame 4 for coating the sensitizing or reinforcing agent onto the both faces of the screen 6.

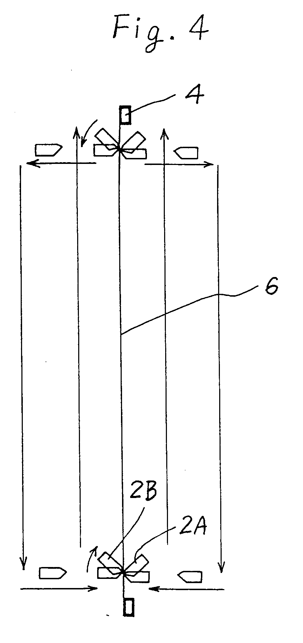

After upwardly movement, the cylinder 18 and 22 are operated by the control means 74 so that the squeegee buckets 2A and 2B are pivotally moved about the pin 16 to horizontal positions and then retracted from the screen 6 of the screen frame 4, as shown in Fig. 4. The motors 50 are then driven reversely so that the carriages 8A, 8B, 10A and 10B and the squeegee buckets 2A and 2B are moved downwardly to the original positions. The squeegee buckets 2A and 2B are then again advanced to be engaged with and pushed against the both faces of the screen 6. The squeegee buckets 2A and 2B are again inclined. The carriages 8A, 8B, 10A and 10B and the squeegee buckets 2A and 2B are then again moved upwardly for coating the sensitizing or reinforcing agent onto the both faces of the screen 6. The steps are done to coat the sensitizing or reinforcing agent two or three times.

After coating, in the upper rail 54, the cylinders 58 is operated by the control means 74 so that the screen frame 4 is released from the plungers of the cylinders 58. The screen frame 4 can therefore be moved along the upper and lower rails 54 and 56 and passed between the one end pillars 34A and 34B and between the one end carriages 8A and 8B to be drawn out to the exterior. The stop 62 may be retracted from the lower rail 56 so that the screen frame 4 can moved reversely and passed between the other end pillars 36A and 36B and between the other end carriages 10A and 10B to be drawn out to the exterior.

The additional timing belts 68 can be operated by the additional motors 71 so that the additional carriages 64 are moved upwardly or downwardly along the one end and other end pillars 34A and 36A. Accordingly, the upper rail 54 can be moved by the additional carriages 64 to adjust the level thereof in accordance with the size of the screen frame 4. As to the lower rail 56, the stop 62 may be moved along the lower rail 56 to adjust the position thereof in accordance with the size of the screen frame 4.

Accordingly, in order to insert the screen frame 4 between the squeegee buckets 2A and 2B in the apparatus, it is merely required to handle the screen frame 4 on one side of the apparatus and push and pass it between the one end pillars 34A and 34B and between the one end carriages 8A and 8B. Unlike the prior art, it is not required to lift the screen frame 4 to a level above the squeegee buckets 2A and 2B in front of the apparatus, then move the screen frame 4 in the opposed direction of the squeegee buckets 2A and 2B and pass the screen frame 4 over one of the squeegee buckets 2A to insert it between the squeegee buckets 2A and 2B. It is an easy work without difficulty, labour and time to insert the screen frame 4 between the squeegee buckets 2A and 2B.

If desired, the apparatus may be arranged to automatically insert the screen frame 4 between the squeegee buckets 2A and 2B. In this connection, a magazin may be disposed on one side of the apparatus for receiving new screen frames 4 so that the screen frames 4 are successively fed from the magazine and passed between the one end pillars 34A and 34B and between the one end carriages 8A and 8B to be inserted between the squeegee buckets 2A and 2B. A magazine may be disposed on the other side of the apparatus for receiving the screen frames 4 after coating so that the screen frames 4 are successively passed between the other end pillars 36A and 36B and between the other end carriages 10A and 10B and fed into the magazine.

Unlike the prior art, the screen frame 4 may not be caught on the edges of the squeegee buckets 2A and 2B when inserted between the squeegee buckets 2A and 2B since it has not to be passed over one of the squeegee buckets 2A and 2B. It can therefore keep the sesitizing or reinforcing agent in the squeegee buckets 2A and 2B from spilling. It can also keep the screen 6 of the screen frame 4 from being damaged.

In addition, if vibrations are generated on the squeegee buckets 2A and 2B when the squeegee buckets 2A and 2B are moved along the screen 6 of the screen frame 4, the vibrations are transmitted to the one end carriages 8A and 8B separately from each other and transmitted to the other end carriages 10A and 10B separately front each other. The vibrations are then transmitted to the one end pillars 34A and 34B separately from each other and transmitted to the other end pillars 36A and 36B separately from each other. Accordingly, a resonance is not generated between the squeegee buckets 2A and 2B. The apparatus can therefore coat the sensitizing or reinforcing agent onto the both faces of the screen 4 without making it uneven or striped.

## Claims

1. A silk or metal screen coating apparatus including a pair of squeegee buckets between which a screen frame is inserted, said screen frame extending vertically between said squeegee buckets and defining an opening surrounded by the periphery thereof, a silk or metal screen being stretched in the opening and held by the periphery of said screen frame, said squeegee buckets extending horizontally to be opposed to each other on the opposite sides of said screen frame, a sensitizing or reinforcing agent being received in said squeegee buckets, said squeegee buckets being moved upwardly along said screen for coating said sensitizing or reinforcing agent onto the both faces of said screen, said apparatus comprising:
a pair of one end carriages disposed in positions corresponding to one ends of said squeegee buckets and spaced from each other in the opposed direction of said squeegee buckets, said squeegee buckets being carried at one ends by said one end carriages separately from each other; and
a pair of one end pillars extending vertically, disposed in positions corresponding to said one ends of said squeegee buckets and spaced from each other in the opposed direction of said squeegee buckets, said one end carriages being engaged with said one end pillars separately from each other to be moved upwardly along said one end pillars so that said squeegee buckets are moved upwardly along said screen, whereby said screen frame can be passed between said one end pillars and between said one end carriages to be inserted between said squeegee buckets.

2. An apparatus as set forth in calim 1, further comprising:
a pair of other end carriages disposed in positions corresponding to the other ends of said squeegee buckets and spaced from each other in the opposed direction of said squeegee buckets, said squeegee buckets being carried at the other ends by said other end carriages separately from each other; and
a pair of other end pillars extending vertically, disposed in positions corresponding to said other ends of said squeegee buckets and spaced from each other in the opposed direction of said squeegee buckets, said other end carriages being engaged with said other end pillars separately from each other to be moved upwardly along said other end pillars so that said squeegee buckets are moved upwardly along said screen, whereby said screen frame can be passed between said other end pillars and between said other end carriages to be drawn out to the exterior.

3. An apparatus as set forth in claim 2, wherein said one end and other end carriages include rollers mounted thereon for rotation and engaged with said one end and other end pillars so that said one end and other end carriages can be moved upwardly and downwardly along said one end and other end pillars, respectively, said one end and other end pillars being fixedly mounted on the base frame of the apparatus, said base frame being supported by casters for movement along a floor.

4. An apparatus as set forth in claim 3, further comprising:
a pair of one end timing belts extending parallel to said one end pillars and connected to said one end carriages so that said one end carriages can be pulled upwardly and downwardly by said one end timing belts; and
a pair of other end timing belts extending parallel to said other end pillars and connected to said other end carriages so that said other end carriages can be pulled upwardly and downwardly by said other end timing belts.

5. An apparatus as set forth in claim 4, further comprising:
upper and lower rails for said screen frame, said upper and lower rails extending horizontally and parallel to said squeegee buckets in positions above and below said squeegee buckets so that said screen frame is moved along said upper and lower rails to be inserted between said squeegee buckets.

6. An apparatus as set forth in claim 5, further comprising:
a pair of cylinders mounted on said upper rail, plungers being received in said cylinders to be pushed against said screen frame so that said screen frame can be fixedly held by said plungers of said cylinders;
rollers installed in said lower rail for rotation so that said screen frame is supported on said rollers for movement; and
a stop mounted on said lower rail so that said screen frame can be engaged with and stopped by said stop.

7. An apparatus as set forth in claim 6, further comprising:
additional carriages by which said upper rail is carried at one end and at the other end, said additional carriages including rollers mounted thereon for rotation and engaged with said one end and other end pillars so that said additional carriages can be moved upwardly and downwardly along said one end and other end pillars;
additional timing belts extending parallel to said one end and other end pillars and connected to said additional carriages so that said additional carriages can be pulled upwardly and downwarly by said additional timing belts, said upper rail being moved upwardly or downwardly by said additional carriages to adjust the level thereof in accordance with the size of said screen frame; and
means for moving said stop along said lower rail to adjust the position thereof in accordance with the size of said screen frame.
